(19) Europäisches Patentamt / European Patent Office / Office européen des brevets

(11) **EP 2 789 966 B1**

(12) **EUROPÄISCHE PATENTSCHRIFT**

(45) Veröffentlichungstag und Bekanntmachung des Hinweises auf die Patenterteilung:
**10.01.2018 Patentblatt 2018/02**

(51) Int Cl.:
*G01L 9/00* (2006.01)          *G01L 1/16* (2006.01)
*G01B 7/00* (2006.01)

(21) Anmeldenummer: **14160892.7**

(22) Anmeldetag: **20.03.2014**

(54) **DEHNUNGSMESSSENSOR**

EXTENSION MEASURING SENSOR

CAPTEUR DE MESURE D'EXPANSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.04.2013 DE 102013103494**

(43) Veröffentlichungstag der Anmeldung:
**15.10.2014 Patentblatt 2014/42**

(73) Patentinhaber:
• **Pro-micron GmbH & Co. KG**
**87600 Kaufbeuren (DE)**
• **Horst Siedle GmbH & Co. KG.**
**78120 Furtwangen (DE)**

(72) Erfinder:
• **Helbig, Christian**
**87674 Ruderatshofen (DE)**
• **Lotz, Sebastian**
**87668 Rieden-Zellerberg (DE)**

(74) Vertreter: **Raffay & Fleck**
**Patentanwälte**
**Grosse Bleichen 8**
**20354 Hamburg (DE)**

(56) Entgegenhaltungen:
EP-A1- 2 056 085          US-A- 4 213 104
US-A- 4 216 401          US-A- 4 296 347
US-A- 4 422 055          US-A- 5 345 201
US-A1- 2006 197 407

EP 2 789 966 B1

**Beschreibung**

Die Erfindung betrifft einen Dehnungsmesssensor, der ein nach dem SAW-Prinzip arbeitendes Sensorelement aufweist, welches mit einem Fügematerial mit einer Basis verbunden ist.

Als ein nach dem SAW-Prinzip arbeitendes Sensorelement, welches Bestandteil eines gattungsgemäßen Dehnungsmesssensors ist, wird ein akustische Oberflächenwellen, kurz auch OFW bzw. SAW (letzteres aus dem Englischen abgeleitet von Surface Acustic Waves) und deren von äußeren Einflüssen abhängigen Laufeigenschaften ausnutzendes Sensorelement bezeichnet. Derartige Sensorelemente umfassen typischerweise einen piezoelektrisch aktiven Trägerkristall, auf dem auf einer Sensoroberfläche Strukturierungen aufgebracht sind, wie insbesondere Wandlerstrukturen und akustische Reflektoren. Durch elektrische Anregung des Trägerkristalls entstehen auf der Sensoroberfläche Oberflächenwellen, die sich mit einer Ausbreitungsgeschwindigkeit über diese Sensoroberfläche ausbreiten. Für die Ausbildung von Dehnungssensoren mit solchermaßen nach dem SAW-Prinzip arbeitenden Sensorelementen wird der Effekt ausgenutzt, dass Laufzeiten der Oberflächenwellen zwischen auf der Oberfläche des Sensorelementes angeordneten Strukturen von auf dem Sensorelement lastenden mechanischen Spannungen (Verformungen) abhängig sind, eine Relation zwischen dem Maß entsprechender Spannungen und einer davon abhängigen Veränderung der Ausbreitungsgeschwindigkeit der Oberflächenwellen hergestellt und damit durch Bestimmung der Laufzeiten bzw. deren Veränderungen auf ein auflastendes Maß an mechanischer Spannung bzw. Verformung geschlossen werden kann.

Derartige nach dem SAW-Prinzip arbeitende Sensorelemente wie auch mit solchen ausgerüstete Dehnungsmesssensoren finden insbesondere überall dort Einsatz, wo im Bereich hoher Temperaturen oder sonstiger extremer Umweltbedingungen gemessen werden muss oder wo eine Anbindung des Sensors über eine Verkabelung nicht oder nur sehr schwer möglich ist. Denn nach dem SAW-Prinzip arbeitende Sensorelemente sind zum einen sehr beständig gegenüber hohen Temperaturen oder sonstigen extremen Umwelteinflüssen, wie z.B. Strahlung oder starken elektrostatischen Felder. Zum anderen können sie drahtlos abgefragt werden, was eine Übermittlung der Messdaten von schwer zugänglichen Messstellen aus erheblich vereinfacht.

Die Basis des Dehnungsmesssensors wird dabei häufig ein eigenständiges und von dem zu vermessenen Objekt unabhängiges Element sein, welches als Grundlage bzw. Unterlage des darauf insgesamt aufgebauten Dehnungsmesssensors dient und über das der Dehnungsmesssensors dann an ein zu messendes Objekt angebunden, bzw. an diesem festgelegt wird. Allerdings ist es ebenfalls möglich, dass die Basis des Dehnungsmesssensors aus dem Material des messtechnisch zu erfassenden Gegenstandes selbst besteht, dass mit anderen Worten der zu messende bzw. messtechnisch zu überwachende Gegenstand an sich bzw. ein Abschnitt desselben die Basis bildet, das Sensorelement unter Verwendung des Fügematerials unmittelbar auf diesen Gegenstand aufgebracht und dort festgelegt ist. Diese Art der Anwendung ist im aktuellen Gebrauch allerdings die Ausnahme.

Heute bekannte Dehnungsmesssensoren, die mit nach dem SAW-Prinzip arbeitenden Sensorelementen versehen sind, haben als Fügematerial zwischen dem Sensorelement und der Basis in der Regel harzbasierende oder andere organische Klebstoffe, wie beispielsweise Epoxidharz. Im Gebrauch haben sich hinsichtlich dieses Fügematerials jedoch verschiedentliche Unzulänglichkeiten herausgestellt. So gasen derartige harzbasierende Klebstoffe auch noch nach längerer Zeit chemische Substanzen aus, beispielsweise enthaltene Lösungsmittel und dgl., die sich auf der Sensoroberfläche des nach dem SAW-Prinzip arbeitenden Sensorelementes niederschlagen. Die Anbindung derartiger Fremdstoffe auf der Sensoroberfläche führt jedoch ihrerseits zu einer Veränderung der Laufeigenschaften der Oberflächenwellen, verfälscht bzw. verändert mithin das Messergebnis des Sensors und führt zu Fehlmessungen. Darüber hinaus reichen harzbasierte Verbindungen hinsichtlich ihrer Temperaturbeständigkeit nicht in für den Einsatz entsprechender Dehnungsmesssensoren in bestimmten Fällen erforderliche Temperaturbereiche hinein, die bis hin zu einem Einsatz bei 400°C und sogar darüber liegen können. Zudem neigen harzbasierte und auch sonstige organische Klebeverbindungen der bekannten Art zum Altern, so dass eine zuverlässige Standdauer eines mit solchem Fügematerial gebildeten Dehnungsmesssensors zeitlich begrenzt ist.

Ein weiterhin bekanntes Problem harzbasierter oder organischer Fügemittel ist das sog. Kriechen. Für den Sensor hat dieser Effekt zur Folge, dass eine über eine längere Zeit einwirkende Spannung allmählich im Fügemittel abgebaut wird, indem sich das Fügemittel dehnt, so dass der Messwert des Sensorelements unter diesen Umständen fälschlicherweise zum Wert des entspannten Zustands driftet. Wird ein derart aufgebauter Sensor nach einem solchen längeren Spannungszustand wieder entspannt, so führt die nun eingeprägte Dehnung des Fügemittels wiederum zu einer auf das Sensorelement wirkenden Spannung, die allein durch das Fügemittel verursacht wird, obwohl keine äußere mechanische Spannung anliegt. Der Sensorwert deutet in diesem Zustand einen Spannungsbetrag an, der fälschlicherweise ungleich Null ist. Dieses Verhalten ist als Hysterese bekannt. Schließlich besteht bei bekannten Fügemethoden häufig das Problem, dass ein Teil der auf die Basis einwirkenden Spannungen bzw. Verformungen nicht bis in das Sensorelement weitergeleitet, sondern durch eine Verformung der Schicht des Fügematerials abgepuffert wird, da letzteres nicht hart genug ist. Auch dies führt zu einem Messfehler mit den bekannten Dehnungsmesssensoren oder zumindest zu einer stark reduzierten Dehnungssensivität des Sensors im Vergleich zu solchen mit härteren Fügematerialien US 4 296 347 A, US 5 345 201 A, US 4 213 104 A, US 4 216 401 A, EP 2 056 085 A1, US 2006/0197407 A1 und US 4 422 055 A offenbaren Dehnungsmesssensoren mit einem nach dem SAW-Prinzip arbeitenden Sensorelement. Hier also Abhilfe zu schaffen und wie eingangs bezeichnete Dehnungsmesssensoren dahingehend weiterzubilden, dass sie die oben bezeichneten Nachteile nicht mehr aufweisen, ist Aufgabe der Erfindung.

Diese Aufgabe wird erfindungsgemäß durch die Merkmale des Vorrichtungsanspruchs 1 gelöst. Vorteilhafte Weiterbildungen eines erfindungsgemäßen Dehnungsmesssensors sind in den abhängigen Ansprüchen 2 bis 5 angegeben. Nach einem weiteren Aspekt der Erfindung besteht diese auch in einem Verfahren zum Bilden eines Dehnungsmesssensors mit den Merkmalen des Patentanspruches 6. Weiterbildungen des erfindungsgemäßen Verfahrens sind in den abhängigen Ansprüchen 7 bis 10 bezeichnet.

Erfindungswesentlich ist hier die Auswahl des Fügematerials als ein Glaslot.

Unter einem Glaslot wird ein Glas mit besonders niedriger Erweichungstemperatur verstanden, welches typischerweise zum Verbinden von Gegenständen aus Glas und als Isolationsmaterial bei Durchführungen von elektrischen Leitern durch metallische Gehäuse Verwendung findet. Hauptbestandteile typischer Glaslote sind Bor und Bleioxid. Ein bekannter Hersteller von Glasloten, die Firma Schott aus Landshut, Deutschland, nennt im Hinblick auf unterschiedliche Klassen von Glasloten folgende Hauptklassen (wobei hierdurch nicht zwingend alle möglichen Glaslote erfasst sind): Borsilikat-Gläser, Erdalkali-Aluminiumsilikat-Gläser, Alkali-Bleisilikat-Gläser, Alkali-Erdalkali-Silikat-Gläser.

Erweichungstemperaturen von Glaslot liegen dabei z.B. bei 400°C und damit unterhalb derjenigen von Glas, das typische Erweichungstemperaturen im Bereich von 600 bis 1000°C hat. Glaslote werden je nach ihrer Art und Zusammensetzung bei Temperaturen zwischen 350°C und 700°C verarbeitet.

Glaslot als Fügematerial hat dabei den Vorteil einer hohen Temperaturbeständigkeit, es zeigt keine wesentlichen Alterungserscheinungen, es verhält sich weitgehend starr im Hinblick auf die Übertragung von Materialspannungen oder Verformungen über die Basis bis zum mit Glaslot angeschlossenen Sensorelement und es ist chemisch inert, zeigt also keinerlei die Messwerte des auf dem SAW-Prinzip basierenden Sensorelementes potentiell verfälschenden chemischen Ausgasungen oder sonstige Absonderungen. Dabei sind insbesondere auch keine Hystereseeffekte des Messverhaltens des mittels Glaslot an die Basis angebundenen Sensorelementes zu befürchten, wie diese bei organischen Klebeverbindungen mit Harzen zu beobachten sind. Begründet liegen diese außergewöhnlich vorteilhaften Eigenschaften in der chemischen Zusammensetzung des Glaslots, das sich durch eine weitestgehend vollständige Vernetzung mit inerten chemischen Bindungsverhältnissen auszeichnet, wie sie beispielsweise typisch für Keramiken sind, während organische Fügemittel aus Molekülen bestehen, die untereinander nicht vollständig vernetzt sind und zudem relativ schwache organische Bindungen aufweisen.

Zudem eröffnet die Verwendung von Glaslot als Fügematerial die Möglichkeit von Herstellungsverfahren, die gegenüber solchen, bei denen organische Klebstoffe zum Einsatz kommen, deutlich vereinfacht, da insbesondere weniger zeitkritisch sind. Denn bei der Verwendung von organischen Klebstoffen muss der dabei ablaufende chemische Prozess geführt werden, was ein zeitkritisches Moment hervorruft. Bei der Verwendung von Glaslot hingegen, sind die physikalische Erweichung und Verfestigung nicht zeitkritisch.

Bei der Durchführung von Versuchsreihen mit verschiedenen Materialkombinationen unterschiedlicher Ausgangsmaterialien der Basis, des Sensorelementes, genauer seines Trägerkristalls, also des typischerweise piezoelektrischen Kristalls, und des Glaslotes haben die Erfinder festgestellt, dass nicht bei jeder beliebigen Kombination für die jeweiligen Bestandteile möglicher Materialien gute Ergebnisse hinsichtlich der Verbindungsstabilität und sensorischen Eigenschaften erzielt werden konnten. Bei einigen Kombinationen unterschiedlicher Materialien für die genannten Komponenten ließen sich überhaupt keine verwertbaren Dehnungsmesssensoren unter Verwendung des Glaslotes als Fügematerial herstellen. Bei der Analyse dieser verschiedenen Messergebnisse haben die Erfinder festgestellt, dass ein Schlüsselmerkmal für ein besonders gutes Ergebnis das Verhältnis der thermischen Ausdehnungskoeffizienten der beteiligten Materialien ist. Dies gilt im Besonderen für das Zustandebringen einer die Funktionalität und Exaktheit des Dehnungsmesssensors bestimmenden, stabilen und die im Zuge der Messung in der Basis auftretenden, von dem Sensorelement zu bestimmenden Verformungen bzw. Spannungen zuverlässig zwischen diesen beiden Elementen übermittelnden Fügeschicht. Bei den Versuchen haben die Erfinder ferner festgestellt, dass eine Druckspannung im Fügeprozess in der durch das Glaslot gebildeten Fügematerialschicht die besten und zuverlässigsten Ergebnisse so gebildeter Dehnungsmesssensoren ergaben. Die hier erkannten Grundbedingungen sind:

Nach einer ersten wesentlichen Bedingung darf der thermische Ausdehnungskoeffizient des Materials der Basis sich nicht zu stark von dem thermischen Ausdehnungskoeffizienten des Materials des Trägerkristalls des Sensorelementes unterscheiden. Dabei haben sich Rahmenwerte dieser ersten Relation als geeignete Bedingungen schaffend erwiesen, für die gilt,

$$CTE_{SAW} - 3 \leq CTE_{Basis} \leq CTE_{SAW} + 7,$$

wobei $CTE_{SAW}$ den thermischen Ausdehnungskoeffizienten des Trägerkristalls bezeichnet, $CTE_{Basis}$ den thermischen Ausdehnungskoeffizienten des Materials der Basis bezeichnet und die Einheit der Werte für die Ausdehnungskoeffizienten in dieser Relation in ppm/K gegeben ist.

Eine zweite wesentliche Bedingung besteht darin, dass der thermische Ausdehnungskoeffizient des verwendeten Glaslotes um ein Mindestmaß kleiner sein muss als derjenige des Materials der Basis. Hier haben die Erfinder folgende Relation für geeignet erkannt:

$$CTE_{Glaslot} \leq CTE_{Basis} - 2,$$

wobei $CTE_{Glaslot}$ der thermische Ausdehnungskoeffizient des Glaslotes, $CTE_{Basis}$ der thermische Ausdehnungskoeffizient des Materials der Basis und die Einheiten der Werte für die thermischen Ausdehnungskoeffizienten in ppm/K angegeben sind.

Thermische Ausdehnungskoeffizienten sind nicht nur vom jeweiligen Material abhängige Werte, sondern hängen in Ihrem Wert in der Regel auch selbst von der Temperatur ab. Die hier zugrunde gelegten thermischen Ausdehnungskoeffizienten des Trägerkristalls ($CTE_{SAW}$), des Glaslots ($CTE_{Glaslot}$) und des Materials der Basis ($CTE_{Basis}$) sind daher als Mittelwerte über einen vorbestimmten Temperaturbereich zu verstehen. Hierfür wird ein Temperaturbereich von Raumtemperatur (hier angenommen als (20°C) und einer unterhalb typischer Transformationstemperaturen des beteiligten Glaslots (hier angenommen mit 300°C) berücksichtigt, über den eine typischerweise arithmetische Mittlung erfolgt. Die Bestimmung des thermischen Ausdehnungskoeffizienten des Glaslots $CTE_{Glaslot}$ in seinem Mittelwert über einen Temperaturbereich erfolgt dabei nach der hierfür einschlägigen Norm ISO 7991. Hier werden für die Werte $CTE_{Glaslot}$ solche aus dem Temperaturbereich zwischen 20°C und 300°C zugrunde gelegt. Dort, wo dieser Wert nicht angegeben ist, wird hier auch auf einen Mittelwert der Werte aus dem Temperaturbereich 20°C bis 250°C zurückgegriffen. Letzteres ist problemlos möglich, da sich die thermischen Ausdehnungskoeffizienten zu höheren Temperaturen hin zunächst nicht wesentlich ändern. So unterscheiden sich diese Werte für ein typisches Glaslot der Firma Schott AG, das Glaslot mit der Glasnummer G018-256, nach den Angaben des Herstellers kaum mit einem Mittelwert von 9,2 ppm/K für einen Temperaturbereich von 20°C bis 250°C und 9,6 ppm/K für einen Temperaturbereich von 20°C bis 300°C. Insoweit können hier auch andere, leicht abweichende Grenzen des für die Mittelwertbildung zugrunde gelegten Temperaturbereichs gewählt sein. Auch die untere, bei Raumtemperatur zu legende Grenze des Intervalls kann variieren, z.B. mit 25°C angenommen werden.

Wenn, was bei bestimmten Materialien vorkommen kann, insbesondere bei dem Material des Trägerkristalls des SAW regelmäßig der Fall ist, der Wert des thermischen Ausdehnungskoeffizienten zudem (z.B. aufgrund einer Anisotropie des Materials) von einer betrachteten Richtung (insbesondere der Richtung einer ausgesuchten Kristallachse) abhängt, so wird für die Zwecke der Erfindung auf einen Wert abgestellt, dessen Ermittlung von der Dimensionierung des Bauteils abhängig ist. Weist dieses eine deutlich unterschiedliche Erstreckung entlang der linear unabhängigen Kantenrichtungen einer zu der Mess-Oberfläche des SAW parallelen Ebene auf (insbesondere ein Verhältnis von 2:1 oder mehr), so wird der thermische Ausdehnungskoeffizient berücksichtigt, der für die Richtung der längeren Erstreckung gilt. Liegen die Kantenlängen hingegen in einer ähnlichen Größenordnung (also z.B. ein Verhältnis von 1:1,5 oder weniger), so wird ein Mittelwert der für die beiden Richtungen geltenden thermischen Ausdehnungskoeffizienten herangezogen.

Für solche Experimentbeispiele bzw. Ausführungsformen, für die die Materialkombinationen die oben genannten Bedingungen nicht erfüllten, ergaben weitergehende Untersuchungen unzureichende Scherfestigkeiten der Verbindungen. Mit unzureichenden Scherfestigkeiten waren solchermaßen hergestellte Dehnungsmesssensoren nicht mehr, zumindest nicht mehr in dem erforderlichen Umfang, praxistauglich. In besonders großen Extremen waren bereits nach Abschluss des Fügeprozesses Risse im Glaslot zu erkennen, die zu einem nicht reproduzierbaren Messverhalten des Sensors führen.

Hinsichtlich der zweiten oben genannten Bedingung ist der Unterschied von 2 ppm/K, um den der thermische Ausdehnungskoeffizient des Glaslotes kleiner sein soll als derjenige des Materials der Basis, ein Mindestwert. Einen Höchstwert hinsichtlich dieser Bedingung konnten die Erfinder nicht feststellen, so wurden auch Materialkombinationen untersucht, bei denen dieser Unterschied bis zu 10 ppm/K betrugt und die dennoch sehr gute Ergebnisse mit sehr präzisen und belastbaren Dehnungsmesssensoren erbrachten. Vielmehr ist es so, dass bei größeren Differenzen der thermischen Ausdehnungskoeffizienten $CTE_{Glaslot}$ und $CTE_{Basis}$ sogar noch bessere Ergebnisse, insbesondere noch höhere Scherfestigkeiten, erzielt werden konnten, so dass sich ein noch besseres Ergebnis ergab, wenn die Relation $CTE_{Glaslot} \leq CTE_{Basis} - 4$ oder gar $CTE_{Glaslot} \leq CTE_{Basis} - 8$ eingehalten wurde.

Hingegen haben die Erfinder festgestellt, dass dann, wenn der Unterschied zwischen den thermischen Ausdehnungskoeffizienten des Trägerkristalls und dem thermischen Ausdehnungskoeffizienten des Materials der Basis sich weiter verringert, sich noch verbesserte Ergebnisse im Hinblick auf die Qualität der so gebildeten Dehnungsmesssensoren erreichen ließen. Auch wenn sich bereits mit der oben genannten Bedingung

$$CTE_{SAW} - 3 \leq CTE_{Basis} \leq CTE_{SAW} + 7$$

gute Ergebnisse erzielen lassen, so wird hinsichtlich dieser Relation ein enger gestecktes Feld in einer vorteilhaften Ausgestaltung der Erfindung bevorzugt mit der Relation:

$$CTE_{SAW} - 1 \leq CTE_{Basis} \leq CTE_{SAW} + 5,$$

wobei auch hier wiederum die Einheit der Werte für die thermischen Ausdehnungskoeffizienten in ppm/K anzugeben ist.

Nicht zuletzt deshalb, da entsprechende Dehnungsmesssensoren häufig auf Metallen aufzubringen sind, aber auch, da dieses Material für die Verwendung zur Herstellung der Basis besonders robust ist, eine gute Durchleitung von auftretenden Spannungen aufweist und auch in seiner Verbindung zum Glaslot gute Haltbarkeiten zeigt, wird für das Material der Basis Stahl bevorzugt. Stahl bietet - neben anderen Vorzügen - auch den Vorteil, dass eine Basis aus diesem Material eine gute Möglichkeit bietet, den Dehnungssensor an dem Messobjekt anzubringen, da dieses, wie z.B. im Falle von Maschinenelementen, häufig ebenfalls aus Edelstahl gefertigt ist. In verschiedenen Versuchen haben die Erfinder unterschiedliche Edelstähle mit diversen Materialkombinationen des Glaslots und der Trägerkristalle für das Sensorelement getestet und dabei herausgefunden, dass insbesondere austenitische Stähle und Duplexstähle sich für die Verwendung des Materials für die Basis eignen. Ferritische sowie martensitische Stähle erbrachten hier deutlich weniger günstige Ergebnisse und sind insofern nicht zu bevorzugen.

Hinsichtlich des Verfahrensaspektes, der mit der Erfindung zur Lösung der Aufgabe vorgeschlagen wird, wird ein Verfahren zum Bilden eines Dehnungsmesssensors mit einem nach dem SAW-Prinzip arbeitenden Sensorelement vorgeschlagen, welches zumindest folgende Schritte aufweist:

    a. Bereitstellen einer Basis aus einem Basismaterial;
    b. Bereitstellen eines auf dem SAW-Prinzip arbeitenden Sensorelementes mit einem Trägerkristall;
    c. Bereitstellen eines Glaslotes;
    d. Verbinden der Basis mit dem Trägerkristall durch Zwischenlegen, Aufschmelzen und anschließendes Erstarrenlassen des Glaslots.

Der Begriff "Zwischenlegen", wie er in Schritt d. verwendet wird, ist hier in einem weiten Sinne gemeint. So kann das Glaslot als sogenanntes Preform in festem Zustand verwendet und zwischen die Komponenten gelegt werden. Es kann aber auch als Suspension aufgetragen oder auf die Basis und/oder den Trägerkristall aufgedruckt werden. Auch diese Art des Auftrages ist im Sinne der Erfindung als ein "Zwischenlegen" zu verstehen.

Auf diese Weise erhält man im Ergebnis einen Dehnungsmesssensor, der als Fügematerial ein Glaslot aufweist mit allen oben bereits beschriebenen Vorteilen. Auch hinsichtlich des Verfahrens gilt, dass mit besonderem Vorteil die Materialien Basismaterial, Trägerkristall des Sensorelementes und Glaslot so gewählt werden, dass die oben genannten Kriterien und Relationen erfüllt sind. Somit ergeben sich im Ergebnis die oben beschriebenen Vorteile. Auch die Wahl des Materials für die Basis kann bei dem erfindungsgemäßen Verfahren bevorzugt auf Stahl, hierbei insbesondere auf einen austenitischen Stahl oder einen Duplexstahl fallen. Auch mit dieser Auswahl sind die oben bereits bezeichneten Vorteile verbunden.

Für das Schaffen der Verbindung durch Aufschmelzen und anschließendes Erstarrenlassen des Glaslots wird mit Vorteil eine maximale Prozesstemperatur für das Aufschmelzen des Glaslots bei 500°C oder weniger, insbesondere im Bereich zwischen 300°C und 500°C gewählt. Während dieses Verfahrensschrittes gewählte Prozesstemperaturen von oberhalb 500°C können, so haben die Untersuchungen ergeben, zu Schädigungen der Oberflächenstruktur des Sensorelementes und damit zu einer Beeinträchtigung bis hin zum Ausfall der nach dem SAW-Prinzip arbeitenden Sensorfunktion des Sensorelementes führen. Damit ist letztlich das Glaslot bei der Auswahl bevorzugt so zu bestimmen, dass es mit den oben genannten Prozesstemperaturen entsprechenden Temperaturen zum Bilden einer festen und dauerhaften Verbindung verarbeitet werden kann.

Weitere Vorteile und Merkmale ergeben sich aus der nachfolgenden Beschreibung von Ausführungsbeispielen unter Bezugnahme der beigefügten Figur.

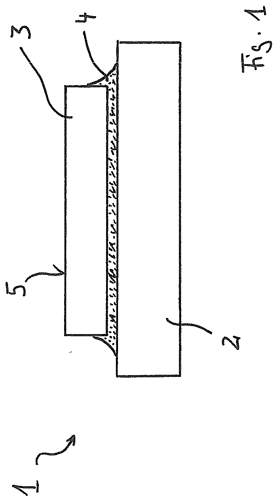

Fig. 1    zeigt eine schematische Darstellung des prinzipiellen Aufbaus eines erfindungsgemäßen Dehnungsmesssensors.

In der Figur ist schematisch ein Ausführungsbeispiel eines erfindungsgemäß gebildeten Dehnungsmesssensors 1 gezeigt. Dieser enthält eine Basis 2 und ein auf der Basis 2 festgelegtes Sensorelement 3. Das Sensorelement 3 arbeitet nach dem SAW-Prinzip. Es ist dafür auf einer in der Figur oben dargestellten, der Basis 2 gegenüberliegenden Sensorfläche 5, entlang derer sich die für die Messung in ihren Eigenschaften ausgewerteten Oberflächenwellen ausbreiten, mit entsprechenden, hinlänglich bekannten und hier nicht näher dargestellten Strukturierungen versehen. Der Korpus des Sensorelements 3 ist aus einem piezoelektrischen Trägerkristall gebildet. Unter "Trägerkristall" ist insoweit nicht ein rein kristallines Material zu verstehen, es kann auch ein (teilweise) amorphes Material, wie etwa eine Keramik sein.

Mittels eines Fügematerials 4 ist das Sensorelement 3 an der Basis 2 festgelegt und mit dieser fest verbunden. Durch das Fügematerial 4 werden an der Basis 2 angreifende mechanische Spannungen oder Dehnungen auf das Sensorelement 3 übertragen und führen dort zu Veränderungen der Lauf- bzw. Ausbreitungseigenschaften der Oberflächenwellen, die als Messergebnis zur Bestimmung der anliegenden mechanischen Spannungen erfasst und ausgewertet werden. Insoweit ist - in diesem allgemeinen Aufbau - der dargestellte Dehnungsmesssensor 1 auch bereits aus dem Stand der Technik bekannt. Das Besondere an dem Dehnungsmesssensor 1 der Erfindung ist, dass das Fügematerial 4 ein Glaslot ist. Dieses führt zu einer sehr festen und temperaturbeständigen Anbindung des Sensorelements 3 an die Basis 2. Es ist chemisch inert, gast nicht aus und kann so keine Messverfälschungen durch auf der Sensorfläche 5 sich niederschlagende chemischen Verbindungen oder Elemente haben, die einer solchen Ausgasung entstammen. Im Messverhalten zeigt ein solchermaßen mit einem Glaslot als Fügematerial 4 gebildeter Dehnungsmesssensor 1 kein Hystereseverhalten.

Um den Dehnungsmesssensor 1 zu bilden, werden eine Basis 2, ein Sensorelement 3 und ein Glaslot als Fügematerial 4 bereitgestellt. Zwischen die Basis 2 und das Sensorelement 3 wird das bei niedrigen Temperaturen starre Glaslot zwischengelegt bzw. in dem Bereich aufgebracht und die Anordnung anschließend erhitzt bis zu einer maximalen Prozesstemperatur von z.B. 400°C. Dabei fließt das Glaslot und bildet eine Verbindung zwischen der Basis 2 und dem Sensorelement 3 aus, ähnlich wie bei einem Lötvorgang zur Verbindung von Metallen mit einem Lotmetall. Beim anschließenden Abkühlen unter die Transformationstemperatur erstarrt das Glaslot, z.B. bei 300°C, und die Verbindung zwischen der Basis 2 und dem Sensorelement 3 wird fest.

Die Basis 2 kann, wie in der Figur gezeigt, ein eigenständiges Element sein, wobei der Dehnungsmesssensor 1 dann durch festes Verbinden (Fügen) der Basis 2 mit einem zu vermessenden Gegenstand für die Messung bzw. Überwachung angeordnet wird. Alternativ kann die Basis aber auch eine Oberfläche des zu vermessenden bzw. zu überwachenden Gegenstandes selbst sein und das Sensorelement 3 mittels eines Glaslots als Fügematerial 4 unmittelbar auf diese Oberfläche aufgebracht werden. Dies kann insbesondere dort geschehen, wo die zu vermessenden bzw. zu überwachenden Gegenstände hinreichend klein und einfach bereits in der Produktion in genannter Weise mit einem Sensorelement 3 bestückbar sind.

In einer Versuchsreihe haben die Erfinder herausgefunden, dass für die Bildung von zuverlässig arbeitenden Dehnungsmesssensoren hinsichtlich der thermischen Ausdehnungskoeffizienten der beteiligten Elemente folgende Rahmenbedingungen günstigerweise eingehalten werden sollten:

i) $CTE_{SAW} - 3 \leq CTE_{Basis} \leq CTE_{SAW} + 7$,
ii) $CTE_{Glaslot} \leq CTE_{Basis} - 2$,

wobei $CTE_{SAW}$ den thermischen Ausdehnungskoeffizienten des Trägerkristalls des nach dem SAW-Prinzip arbeitenden Sensorelements 3, $CTE_{Basis}$ den thermischen Ausdehnungskoeffizienten des Basismaterials und $CTE_{Glaslot}$ den thermischen Ausdehnungskoeffizienten des Glaslots bezeichnen und die Einheit der Werte für die thermischen Ausdehnungskoeffizienten in ppm/K gegeben ist. Die Bestimmung und Festlegung des zu berücksichtigenden Wertes des jeweiligen thermischen Ausdehnungskoeffizienten erfolgt dabei nach den vorstehend bereits beschriebenen Kriterien für eine Mittelung über einen Temperaturbereich und für die Festlegung der relevanten Richtung bzw. einer auch in Bezug auf eine Richtungsabweichung vorzunehmenden Mittelung.

Als besonders zu bevorzugen hat sich hinsichtlich der ersten oben genannten Bedingung eine noch engere Grenze mit

i) $CTE_{SAW} - 1 \leq CTE_{Basis} \leq CTE_{SAW} + 5$,

herausgestellt.

Auch (und dies unabhängig von den Grenzen der Relation i)) wurden bessere Ergebnisse erhalten, wenn die Relation der Bedingung ii) strenger gefasst wurde zu

ii) $CTE_{Glaslot} \leq CTE_{Basis} - 4$, oder gar
ii) $CTE_{Glaslot} \leq CTE_{Basis} - 8$.

Für die Basis 2 wird bevorzugt Stahl als Material gewählt, wobei sich austenitische Stähle und Duplexstähle als besonders geeignet herausgestellt haben.

Für Vergleichsexperimente haben die Erfinder Trägerkristalle für das auf dem SAW-Prinzip basierende Sensorelement 3 aus Quarz mit unterschiedlichen Schnittebenen für die Sensorfläche 5 verwendet. Dieses Material besitzt in Richtung unterschiedlicher Kristallachsen verschiedene thermische Ausdehnungskoeffizienten ($CTE_{SAW}$). Aus diesem Trägerkristall des Sensorelements 3 wurde ein langgestrecktes Element geschnitten mit einer Längsrichtung, d.h. einer Richtung, in der das Sensorelement eine deutlich größere Längenausdehnung aufwies als in einer Richtung quer dazu, entlang derer eine Kristallachse lag, in deren Richtung der thermische Ausdehnungskoeffizient $CTE_{SAW}$ etwa 15 ± 1 ppm/K betrug. In einer Richtung quer dazu (also der Richtung der kürzeren Kantenlänge des Sensorelementes) lag in Abhängigkeit des Schnittes der thermische Ausdehnungskoeffizient hingegen bei 12 ± 2 ppm/K (da diese Richtung nicht entlang einer Kristallachse lag, sondern entlang einer Richtung, die Komponenten beider Kristallachsen in etwa gleicher Gewichtung enthielt, wurde ein Mittelwert der beiden in Richtung der Kristallachsen geltenden Werte genommen).

Im Besonderen wurde dabei ein Quarzkristall mit einer Sensoroberfläche entlang einer Schnittebene 36°rotYX oder gemäß IEEE: (YXI) 36° verwendet.

In den Vergleichsexperimenten wurden unterschiedliche Stähle als Material für die Basis 2 verwendet. Es wurden dabei Edelstähle aus den verschiedenen Untergruppen untersucht. Ferritische sowie martensitische Stähle liegen mit ihren thermischen Ausdehnungskoeffizienten $CTE_{Basis}$ bei Werten von etwa 10,5 bis 11,5 ppm/K. Ein typischer Vertreter eines solchen Stahls ist der ferritische Stahl 1.4016.

Duplex-Stähle (ferritisch-austenitische Stähle) liegen mit thermischen Ausdehnungskoeffizienten $CTE_{Basis}$ bei etwa 14 ppm/K. Hier ist ein typischer Vertreter der Stahl 1.4462.

Austenitische Stähle haben einen thermischen Ausdehnungskoeffizienten $CTE_{Basis}$ von ca. 17 ppm/K. Ein typischer Vertreter ist hier der Stahl 1.4301.

Die Versuche wurden mit unterschiedlichen Glasloten durchgeführt. Dabei hat es sich herausgestellt, dass es nur sinnvoll ist, solche Glaslote zu verwenden, die einen kleineren thermischen Ausdehnungskoeffizienten $CTE_{Glaslot}$ als der thermische Ausdehnungskoeffizient $CTE_{Basis}$ des verwendeten Stahls aufweisen.

Temperaturen oberhalb etwa 500 °C führen zu Schädigungen des auf dem SAW-Prinzip basierenden Sensorelements 3 und können daher nicht gefahren werden. Deshalb wurden solche Glaslote verwendet, die entsprechende Verarbeitungstemperaturen unterhalb 500°C aufweisen. Beispielsweise sind dies Glaslote des Herstellers Schott AG, wie sie mit ihren thermischen Ausdehnungskoeffizienten in der nachstehenden Tabelle 1 aufgelistet sind.

Tabelle 1

| Glaslotbezeichnung | $CTE_{Glaslot}$ in ppm/K |
|---|---|
| Schott G018-228 | 7,6* |
| Schott G018-256 | 9,6* |
| Schott 8472 | 12** |
| *Angaben des Herstellers nach Datenblatt; Ausdehnungskoeffizient gemittelt über einen Temperaturbereich von 20°C (Raumtemperatur) bis 300°C nach ISO 7991. **Angaben des Herstellers nach Datenblatt; Ausdehnungskoeffizient gemittelt über einen Temperaturbereich von 20°C (Raumtemperatur) bis 250°C nach ISO 7991. | |

Bei den Versuchen zur Verbindung der Elemente wurde zunächst beurteilt, ob die gewünschte Verbindung nach optischer Analyse (optische Begutachtung frei und in Vergrößerung unter Lupe und Mikroskop) einwandfrei zustande kam. Hierzu gehört, dass das Glaslot und der Trägerkristall des nach dem SAW-Prinzip arbeitenden Sensorelements 3 rissfrei und unversehrt vorliegen.

Weiterhin wurde an den unterschiedlichen Dehnungsmesssensoren die Scherkraft gemessen, bei der die Verbindung zwischen der Basis 2 und dem Sensorelement 3 versagte. Daraus konnte die Scherfestigkeit in MPa berechnet werden, indem die Kraft durch die abgescherte Fläche (in den durchgeführten Versuchen 4 mm$^2$) dividiert wurde.

Im Ergebnis erbrachten die Vergleichsversuche Folgendes:

- Auf ferritischen bzw. martensitischen Stählen mit thermischen Ausdehnungskoeffizienten $CTE_{Basis}$ von ca. 11 ppm/K, als Angabe in einem Mittelwert über einen Bereich von Raumtemperatur (20°C) bis 300°C, konnten keine zufriedenstellenden Ergebnisse erzielt werden. Die Glaslotverbindungen sind entweder bereits beim Abkühlprozess komplett gerissen, wiesen danach Schädigungen in Form von Rissen in der Verbindungsschicht auf oder erzielten nur ungenügende Scherfestigkeiten.

- Mit Duplexstählen ($CTE_{Basis}$ von ca. 14 ppm/K, als Angabe in einem Mittelwert über einen Bereich von Raumtemperatur (20°C) bis 300°C) konnten in Verbindung mit einem Glaslot mit einem thermischen Ausdehnungskoeffizienten $CTE_{Glaslot}$ kleiner als 8 ppm/K gute Ergebnisse realisiert werden. Der thermische Ausdehnungskoeffizient $CTE_{Glaslot}$ des Glaslots ist hier also wenigstens 6 ppm/K kleiner als der thermische Ausdehnungskoeffizient $CTE_{Basis}$ des Stahls zu wählen. Er ist zudem auch deutlich kleiner als der thermische Ausdehnungskoeffizient $CTE_{SAW}$, den der Trägerkristall des nach dem SAW-Prinzip arbeitenden Sensorelements hier in der oben genannten Längsrichtung aufweist.

- Bei austenitischen Stählen ($CTE_{Basis}$ von ca. 17 ppm/K, als Angabe in einem Mittelwert über einen Bereich von Raumtemperatur (20°C) bis 300°C) wurden gute Ergebnisse mit Glasloten mit thermischen Ausdehnungskoeffizienten $CTE_{Glaslot}$ zwischen 10 und 12 ppm/K realisiert. Die Differenz zu dem thermischen Ausdehnungskoeffizient $CTE_{Basis}$ des Stahls liegt hier bei 5-7 ppm/K. Die besten Ergebnisse wurden mit solchen Glasloten erzielt, deren thermischer Ausdehnungskoeffizient $CTE_{Glaslot}$ kleiner war als 10 ppm/K. Solche Glaslotverbindungen hielten im Zugversuch Dehnungen des Stahlsubstrates, also der Basis 2, von mehr als 1000 ppm stand.

Ergebnisse der Scherfestigkeitsbestimmungen für verschiedene Kombinationen von Stahl der Basis und Glaslot zur Anbindung eines gegebenen Sensorelements mit einem Quarz als Trägerkristall sind in der nachstehenden Graphik wiedergegeben. Nur solche Messsensoren, die sich in einer optischen Analyse als einwandfrei und ohne Risse herausstellten, wurden bei der in der Graphik dargestellten Analyse berücksichtigt:

Im Ergebnis lässt sich hier also festhalten: Zum Glaslöten von Sensorelement 3 mit einem Trägerkristall aus Quarz (es wurden verschiedene Quarzschnitte erfolgreich aufgelötet) sollten für die Basis 2 Stähle verwendet werden mit einem thermischen Ausdehnungskoeffizienten $CTE_{Basis}$ zwischen 13 und 18 ppm/K, bevorzugt zwischen 14 und 17 ppm/K. Das Glaslot sollte einen thermischen Ausdehnungskoeffizienten $CTE_{Glaslot}$ aufweisen, der um 2 bis 10 ppm/K kleiner ist als der thermische Ausdehnungskoeffizient $CTE_{Basis}$ des Stahls, bevorzugt um 4 bis 8 ppm/K kleiner.

Neben Quarz als Material für den Trägerkristall des SAW können aber auch für diese Anwendung als bekannt geeignete Materialien, wie insbesondere Lithiumniobat ($LiNbO_3$) und Lithiumtantalat ($LiTaO_3$) zur Anwendung kommen. Die Erfinder haben herausgebracht, dass auch diese hervorragend mit Glaslot auf eine Basis aufgebracht werden können und dass auch dort die gleichen Überlegungen zu den bevorzugten Relationen der thermischen Ausdehnungskoeffizienten $CTE_{Basis}$, $CTE_{Glaslot}$ und $CTE_{SAW}$ gelten.

Für die thermischen Ausdehnungskoeffizienten des Trägerkristalls in einer über den bereits genannten Temperaturbereich gemittelten Größe (für die verschiedenen Kristallachsrichtungen) gilt für diese Materialien:

Tabelle 2

| Kristall | $\alpha_{11}$ in ppm/K | $\alpha_{33}$ in ppm /K |
|---|---|---|
| Quarz | 15,3 | 8,6 |

(fortgesetzt)

| Kristall | $\alpha_{11}$ in ppm/K | $\alpha_{33}$ in ppm /K |
|---|---|---|
| LiNbO$_3$ | 16,5 | 4,5 |
| LiTaO$_3$ | 17,5 | 3,5 |

Die Werte für die Ausdehnungskoeffizienten und deren über die genannten Temperaturintervalle geltenden Mittelwerte sind in der Literatur über die betreffenden Materialien zu finden. Für die Basismaterialien, wie insbesondere Stähle, sowie für die Glaslote sind entsprechende Angaben typischerweise in den jeweiligen Datenblättern der Hersteller enthalten. Wie oben bereits erwähnt wird der Fachmann dann, wenn eine relevante Kantenrichtung des Sensorelementes 3 nicht entlang einer Kristallachse liegt, sondern eine Mischrichtung, also eine Richtung mit Komponenten beider Kristallachsrichtungen, ist, für den thermischen Ausdehnungskoeffizienten in dieser Richtung eine geeignete Näherungsberechnung bzw. Abschätzung vornehmen, z.B. eine Mittelwertbildung bzw. eine Approximation anderer Gewichtung, wenn die Komponenten der Kristallachsrichtungen in der Mischrichtung in unterschiedlichem Maß vertreten sind.

Angaben zu den thermischen Ausdehnungskoeffizienten von möglichen Trägerkristallen des SAW finden sich in Bezug auf Quarz, Lithiumtantalat und Lithiumniobat in der Veröffentlichung "The Temperature Coefficients of Acoustic Surface Wave Velocity and Delay on Lithium Niobate, Lithium Tantalate, Quartz and Tellurium Dioxide" von Andrew J. Slobodnik Jr. in Physical Science Resarch Papers No. 477, Air Force Cambridge Resarch Laboratories, 22. Dezember 1977. Daten zu Lithiumniobat finden sich auch in dem Buch "Properties of Lithium Niobate", Herausgeber K.K. Wong, INSPEC, The Institute of Electrical Engineers, London 2002. Werte für Quarz können z.B. auch in der Offenlegungsschrift US 2011/0241492 A1, dort der Fig. 5, entnommen werden.

**Bezugszeichenliste**

1    Dehnungsmesssensor
2    Basis
3    Sensorelement
4    Fügematerial
5    Sensorfläche

**Patentansprüche**

1. Dehnungsmesssensor (1) mit einem nach dem SAW-Prinzip arbeitenden Sensorelement (3), der eine Basis (2) aus einem ersten Material und das Sensorelement (3), welches auf einem Trägerkristall gebildet ist, aufweist, wobei der Trägerkristall des Sensorelements (3) mit einem Fügematerial (4) auf der Basis (2) festgelegt ist, wobei das Fügematerial (4) ein Glaslot ist, **dadurch gekennzeichnet, dass** die Materialkombination aus dem Material der Basis (2), dem Glaslot und dem Trägerkristall des Sensorelementes (3) derart gewählt ist, dass für die thermischen Ausdehnungskoeffizienten der beteiligten Materialien, nämlich den thermischen Ausdehnungskoeffizient des Materials der Basis (2) CTE$_{Basis}$, den thermischen Ausdehnungskoeffizient des Glaslots CTE$_{Glaslot}$ und den thermischen Ausdehnungskoeffizienten des Trägerkristalls des nach dem SAW-Prinzip arbeitenden Sensorelementes (3) CTE$_{SAW}$, folgende Relationen gelten:

i. CTE$_{SAW}$ - 3 $\leq$ CTE$_{Basis}$ $\leq$ CTE$_{SAW}$ + 7,
ii. CTE$_{Glaslot}$ $\leq$ CTE$_{Basis}$ - 2,

wobei die Einheit der Werte für die thermischen Ausdehnungskoeffizienten in ppm/K gegeben ist.

2. Dehnungsmesssensor nach Anspruch 1, **dadurch gekennzeichnet, dass** für den thermischen Ausdehnungskoeffizienten des Materials der Basis (2) und den thermischen Ausdehnungskoeffizienten des Trägerkristalls des nach dem SAW-Prinzip arbeitenden Sensorelements (3) CTE$_{SAW}$, folgende Relation gilt:

i. CTE$_{SAW}$ - 1 $\leq$ CTE$_{Basis}$ $\leq$ CTE$_{SAW}$ + 5,

wobei die Einheit der Werte für die thermischen Ausdehnungskoeffizienten in ppm/K gegeben ist.

3. Dehnungsmesssensor nach einem der Ansprüche 1 oder 2, **dadurch gekennzeichnet, dass** für die thermischen Ausdehnungskoeffizienten des Materials der Basis (2), $CTE_{Basis}$, und den thermischen Ausdehnungskoeffizienten des Glaslots, $CTE_{Glaslot}$, folgende Relation gilt:

    ii. $CTE_{Glaslot} \leq CTE_{Basis} - 4$, insbesondere $CTE_{Glaslot} \leq CTE_{Basis} - 8$.

4. Dehnungsmesssensor nach einem der vorhergehenden Ansprüche, **dadurch gekennzeichnet, dass** das Material der Basis (2) ein Stahl ist.

5. Dehnungsmesssensor nach Anspruch 4, **dadurch gekennzeichnet, dass** das Material der Basis (2) ein austenitischer Stahl oder ein Duplexstahl ist.

6. Verfahren zum Bilden eines Dehnungsmesssensors mit einem nach dem SAW-Prinzip arbeitenden Sensorelement mit folgenden Schritten:

    a. Bereitstellen einer Basis aus einem Basismaterial;
    b. Bereitstellen eines Trägerkristalls, auf dem das Sensorelement gebildet ist;
    c. Bereitstellen eines Glaslots;
    d. Verbinden der Basis mit dem Trägerkristall durch Zwischenlegen, Aufschmelzen und anschließendes Erstarrenlassen des Glaslots

**dadurch gekennzeichnet, dass** die Materialkombination aus Basismaterial, dem Trägerkristall und dem Glaslot des Sensorelements so gewählt wird, dass für die thermischen Ausdehnungskoeffizienten dieser Materialien, also den thermischen Ausdehnungskoeffizienten des Basismaterials $CTE_{Basis}$, den thermischen Ausdehnungskoeffizienten des Trägerkristalls $CTE_{SAW}$ und den thermischen Ausdehnungskoeffizienten des Glaslots $CTE_{Glaslot}$, folgende Relationen gelten:

    i. $CTE_{SAW} - 3 \leq CTE_{Basis} \leq CTE_{SAW} + 7$,
    ii. $CTE_{Glaslot} \leq CTE_{Basis} - 2$,

wobei die Einheit der Werte für die thermischen Ausdehnungskoeffizienten in ppm/K gegeben ist.

7. Verfahren nach Anspruch 6, **dadurch gekennzeichnet, dass** die Kombination aus Basismaterial, Sensorelement mit Trägerkristall und Glaslot so gewählt wird, dass für den thermischen Ausdehnungskoeffizienten des Basismaterials $CTE_{Basis}$ und den thermischen Ausdehnungskoeffizienten des Trägerkristalls des nach dem SAW-Prinzip arbeitenden Sensorelements $CTE_{SAW}$ folgende Relation eingehalten wird:

    i. $CTE_{SAW} - 1 \leq CTE_{Basis} \leq CTE_{SAW} + 5$,

wobei die Einheit der Werte für die thermischen Ausdehnungskoeffizienten in ppm/K gegeben ist.

8. Verfahren nach einem der Ansprüche 6 oder 7, **dadurch gekennzeichnet, dass** die Kombination aus Basismaterial, Sensorelement mit Trägerkristall und Glaslot so gewählt wird, dass für die thermischen Ausdehnungskoeffizienten $CTE_{Basis}$ des Basismaterials und $CTE_{Glaslot}$ des Glaslots folgende Relation eingehalten wird:

    ii. $CTE_{Glaslot} \leq CTE_{Basis} - 4$, insbesondere $CTE_{Glaslot} \leq CTE_{Basis} - 8$.

9. Verfahren nach einem der Ansprüche 6 bis 8, **dadurch gekennzeichnet, dass** als Material der Basis ein Stahl, insbesondere ein austenitischer Stahl oder ein Duplexstahl gewählt wird.

10. Verfahren nach einem der Ansprüche 6 bis 9, **dadurch gekennzeichnet, dass** eine maximale Prozesstemperatur für das Aufschmelzen des Glaslots bei $\leq 500°C$, insbesondere im Bereich zwischen 300°C und 500°C gewählt wird.

**Claims**

1. An extension measuring sensor (1) provided with a sensor element (3) operating according to the SAW-principle, comprising a base (2) composed of a first material and the sensor element (3), which is formed on a carrier crystal, wherein the carrier crystal of the sensor element (3) is attached with a jointing material (4) to the base (2), wherein the jointing material (4) is a glass solder, **characterized in that** the material combination is selected from the material of the base (2), the glass solder and the carrier crystal of the sensor element (3) in such a way that the thermal extension coefficients of the materials involved, i.e. the thermal extension coefficient of the material forming the base (2), CTE-$_{base}$, the thermal extension coefficient of the glass solder CTE-$_{glass\ solder}$ and the thermal extension coefficient of the carrier crystal of the sensor element operating according to the SAW-principle, CTE-$_{SAW}$ are governed by the following relations:

   i. CTE-$_{SAW}$ - 3 ≤ CTE-$_{base}$ ≤ + CTE-$_{SAW}$ 7,
   ii. CTE-$_{glass}$ solder ≤ CTE-$_{base}$ - 2,

   wherein the unit of the values for the thermal extension coefficients is given in ppm/K.

2. The extension measuring sensor according to claim 1, **characterized in that** the thermal extension coefficient of the material of the base (2) and the thermal extension coefficient of the carrier crystal of the sensor element (3) operating according to the SAW-principle, CTE-$_{SAW}$, are governed by the following relation:

   i. CTE-$_{SAW}$ - 1 ≤ CTE-$_{base}$ ≤ CTE-$_{SAW}$ + 5,

   wherein the unit of the values for the thermal extension coefficients is given in ppm/K.

3. The extension measuring sensor according to one of the claims 1 or 2, **characterized in that** the thermal extension coefficient of the material of the base (2), CTE-$_{base}$ and the thermal extension coefficient of the glass solder, CTE-$_{glass\ solder}$ are governed by the following relation:

   ii. CTE-$_{glass}$ solder ≤ CTE-$_{base}$ - 4, in particular CTE-$_{glass}$ solder ≤ CTE-$_{base}$ - 8.

4. The extension measuring sensor according to one of the preceding claims, **characterized in that** the material of the base (2) is a steel.

5. An extension measuring sensor according to claim 4, **characterized in that** the material of the base (2) is an austenitic steel or a duplex steel.

6. A process of producing an extension measuring sensor with a sensor element operating according to the SAW-principle with the following steps:

   a. providing a base made of a base material;
   b. providing a carrier crystal, on which is formed the sensor element;
   c. providing a glass solder;
   d. bonding the base to the carrier crystal by sandwiching, melting and then solidifying the glass solder

   **characterized in that** the material combination is selected from the base material, the carrier crystal and the glass solder of the sensor element in such a way that the thermal extension coefficients of the materials involved, i.e. the thermal extension coefficient of the base material, CTE-$_{base}$, the thermal extension coefficient of the carrier crystal CTE-$_{SAW}$ and the thermal extension coefficient of the glass solder CTE-$_{glass\ solder}$ are governed by the following relations:

   i. CTE-$_{SAW}$ - 3 ≤ CTE-$_{base}$ ≤ CTE-$_{SAW}$ + 7,
   ii. CTE-$_{glass\ solder}$ ≤ CTE-$_{base}$ - 2,

   wherein the unit of the values for the thermal extension coefficients is given in ppm/K.

7. The method according to claim 6, **characterized in that** the combination of base material, sensor element with carrier crystal and glass solder is selected in such a way that the thermal extension coefficient of the base material, CTE-$_{base}$ and the thermal extension coefficient of the carrier crystal of the sensor element operating according to the SAW-principle, CTE-$_{SAW}$, are governed by the following relation:

    i. CTE-$_{SAW}$-1 $\leq$ CTE-$_{base}$ $\leq$ CTE-$_{SAW}$ + 5,

wherein the unit of the values for the thermal extension coefficients is given in ppm/K.

**8.** The method according to any of the claims 6 to 7, **characterized in that** the combination of base material, sensor element with carrier crystal and glass solder is selected in such a way that the thermal extension coefficient of the base material, CTE-$_{base}$ and the thermal extension coefficient of the glass solder, CTE-$_{glass\ solder}$ are governed by the following relation:

    ii. CTE-$_{glass}$ solder $\leq$ CTE-$_{base}$ - 4, in particular CTE-$_{glass}$ solder $\leq$ CTE-$_{base}$ - 8.

**9.** The method according to any of the claims 6 to 8, **characterized in that** the material of the base is a steel, in particular an austenitic steel or a duplex steel.

**10.** The method according to any of the claims 6 to 9, **characterized in that** the maximal treatment temperature for melting the glass solder is < 500°C, in particular in the range between 300°C and 500°C.

**Revendications**

**1.** Capteur de mesure d'expansion (1) doté d'un élément capteur (3) fonctionnant selon le principe de SAW, comprenant une base (2) composée d'un premier matériau et de l'élément capteur (3), qui est formé sur un cristal porteur, dans lequel le cristal porteur de l'élément capteur (3) est fixé avec un matériau d'assemblage (4) à la base (2), dans lequel le matériau d'assemblage (4) est une soudure en verre, **caractérisé en ce que** la combinaison de matériaux est choisie parmi le matériau de base (2), la soudure de verre et le cristal porteur de l'élément capteur (3) de telle manière que les coefficients d'expansion thermique des matériaux impliqués, à savoir le coefficient d'expansion thermique du matériau formant la base (2), CTE-$_{base}$, le coefficient d'expansion thermique de la soudure de verre CTE-$_{soudure\ de\ verre}$ et le coefficient d'expansion thermique du cristal de support de l'élément capteur fonctionnant selon le principe SAW, CTE-$_{SAW}$ sont régis par les relations suivantes:

    i. CTE-$_{SAW}$ - 3 $\leq$ CTE-$_{base}$ $\leq$ + CTE-$_{SAW}$ 7,
    ii. CTE-$_{soudure\ de}$ verre $\leq$ CTE-$_{base}$ - 2,

dans lequel l'unité des valeurs pour les coefficients d'expansion thermique est donnée en ppm/K.

**2.** Capteur de mesure d'expansion selon la revendication 1, **caractérisé en ce que** le coefficient d'expansion thermique du matériau de base (2) et le coefficient d'expansion thermique du cristal porteur de l'élément capteur (3) fonctionnant selon le SAW principe, CTE-$_{SAW}$, sont régis par la relation suivante:

    i. CTE- - 1 $\leq$ CTE-$_{base}$ $\leq$ CTE- + 5,

dans lequel l'unité des valeurs pour les coefficients d'expansion thermique est donnée en ppm/K.

**3.** Capteur de mesure d'expansion selon l'une des revendications 1 ou 2, **caractérisé en ce que** le coefficient d'expansion thermique du matériau de base (2), CTE-$_{base}$ et le coefficient d'expansion thermique de la soudure de verre, CTE-$_{soudure\ de\ verre}$ sont régis par la relation suivante:

    ii. CTE-$_{soudure\ de}$ verre $\leq$ CTE-$_{base}$ - 4, en particulier CTE-$_{soudure\ de\ verre}$ $\leq$ CTE-$_{base}$- 8.

**4.** Capteur de mesure d'expansion selon l'une des revendications précédentes, **caractérisé en ce que** le matériau de la base (2) est un acier.

**5.** Capteur de mesure d'expansion selon la revendication 4, **caractérisé en ce que** le matériau de la base (2) est un acier austénitique ou un acier duplex.

**6.** Procédé de production d'un capteur de mesure de l'expansion d'un élément capteur fonctionnant selon le principe SAW avec les étapes suivantes:

 a. fournir une base en un matériau de base;
 b. fournir un cristal porteur, sur lequel est formé l'élément capteur;
 c. fournir une soudure de verre;
 d. lier la base au cristal porteur par prise en sandwich, fusion puis solidification de la soudure de verre

**caractérisé en ce que** la combinaison de matériaux est choisie parmi le matériau de base, la soudure de verre et le cristal porteur de l'élément capteur de telle manière que les coefficients d'expansion thermique des matériaux impliqués, à savoir que le coefficient d'expansion thermique du matériau de base, $CTE_{base}$, le coefficient d'expansion thermique du cristal porteur $CTE_{SAW}$ et le coefficient d'expansion thermique de la soudure de verre, $CTE_{soudure\ de\ verre}$ sont régis par les relations suivantes:

 i. $CTE_{SAW} - 3 \leq CTE_{base} \leq CTE_{SAW} + 7$,
 ii. $CTE_{soudure\ de\ verre} \leq CTE_{base} - 2$,

dans lequel l'unité des valeurs pour les coefficients d'expansion thermique est donnée en ppm/K.

**7.** Procédé selon la revendication 6, **caractérisé en ce que** la combinaison du matériau de base, de l'élément capteur avec le cristal porteur et de la soudure en verre est sélectionnée de telle manière que le coefficient d'expansion thermique du matériau de base, $CTE_{base}$ et le coefficient d'expansion thermique du cristal porteur de l'élément capteur fonctionnant selon le principe SAW, $CTE_{SAW}$ sont régis par la relation suivante:

 i. $CTE_{SAW} - 1 \leq CTE_{base} \leq CTE_{SAW} + 5$,

dans lequel l'unité des valeurs pour les coefficients d'expansion thermique est donnée en ppm/K.

**8.** Procédé selon l'une quelconque des revendications 6 à 7, **caractérisé en ce que** la combinaison du matériau de base, de l'élément capteur avec le cristal porteur et de la soudure en verre est sélectionnée de telle manière que le coefficient d'expansion thermique du matériau de base, $CTE_{base}$ et le coefficient d'expansion thermique de la soudure de verre, $CTE_{soudure\ de\ verre}$ sont régis par la relation suivante:

 ii. $CTE_{soudure\ de\ verre} \leq CTE_{base} - 4$, en particulier $CTE_{soudure\ de\ verre} \leq CTE_{base} - 8$.

**9.** Procédé selon l'une quelconque des revendications 6 à 8, **caractérisé en ce que** le matériau de la base est un acier, en particulier un acier austénitique ou un acier duplex.

**10.** Procédé selon l'une quelconque des revendications 6 à 9, **caractérisé en ce que** la température de traitement maximale pour la fusion de la soudure de verre est < 500°C, en particulier dans la plage comprise entre 300°C et 500°C.

Fig. 1

EP 2 789 966 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4296347 A
- US 5345201 A
- US 4213104 A
- US 4216401 A
- EP 2056085 A1
- US 20060197407 A1
- US 4422055 A
- US 20110241492 A1

**In der Beschreibung aufgeführte Nicht-Patentliteratur**

- The Temperature Coefficients of Acoustic Surface Wave Velocity and Delay on Lithium Niobate, Lithium Tantalate, Quartz and Tellurium Dioxide. **ANDREW J. SLOBODNIK JR.** Physical Science Resarch Papers No. 477. Air Force Cambridge Resarch Laboratories, 22. Dezember 1977
- Properties of Lithium Niobate. INSPEC. The Institute of Electrical Engineers, 2002